(19) Europäisches Patentamt
European Patent Office
Office européen des brevets

(11) EP 2 991 123 A1

(12) **EUROPEAN PATENT APPLICATION**

(43) Date of publication:
**02.03.2016 Bulletin 2016/09**

(21) Application number: **14182758.4**

(22) Date of filing: **29.08.2014**

(51) Int Cl.:
***H01L 31/048*** *(2006.01)*
***H01L 31/055*** *(2014.01)*
***H01L 31/054*** *(2014.01)*

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicants:
- **Solvay Specialty Polymers Italy S.p.A.**
  **20021 Bollate (MI) (IT)**
- **Politecnico Di Milano**
  **20133 Milano (IT)**

(72) Inventors:
- **Apostolo, Marco**
  **20030 Senago (MI) (IT)**
- **Miozzo, Luciano**
  **21100 Varese (VA) (IT)**
- **Turri, Stefano**
  **20047 Brugherio (MB) (IT)**
- **Griffini, Gianmarco Enrico**
  **20135 Milano (MI) (IT)**
- **Molena, Elena**
  **20131 Milano (MI) (IT)**

(74) Representative: **Benvenuti, Federica et al**
**Solvay S.A.**
**Département de la Propriété Intellectuelle**
**Rue de Ransbeek, 310**
**1120 Bruxelles (BE)**

(54) **Collector for a luminescent solar concentrator**

(57) The present invention pertains to a collector for a luminescent solar concentrator, said collector comprising at least one front layer [layer (F)] made of a composition [composition (C)] comprising at least one thermoplastic partially fluorinated polymer [polymer (F)], at least one polyacrylate [polyacrylate (A)] and at least one luminescent compound [compound (L)].

The present invention further pertains to a process for the manufacture of said collector and to a luminescent solar concentrator comprising said collector.

EP 2 991 123 A1

## Description

### Technical Field

The present invention pertains to a collector for a luminescent solar concentrator, to a process for the manufacture of said collector and to a luminescent solar concentrator comprising said collector.

### Background Art

A luminescent solar concentrator (LSC) typically comprises a collector and, coupled to said collector, at least one photovoltaic cell.

The collector is typically an optically transparent sheet made of a composition comprising a polymer and a luminescent compound.

A substantial fraction of incident solar radiation is absorbed by the luminescent compound trapped in the collector and unveiled via internal reflection to at least one output surface of said collector.

Photovoltaic cells coupled to the output surfaces of the collector then convert the emitted electromagnetic radiation into electric current.

Sheets made from polymers such as polycarbonate and poly(methylmethacrylate) are typically used because of their high optical transparency and high refractive index.

For instance, US 2009/0126778 (SABIC INNOVATIVE PLASTICS IP B.V.) 21.05.2009 discloses a LSC comprising a primary waveguide and a photovoltaic cell, wherein the primary waveguide is made from a composition comprising a polymer, typically a polycarbonate or an acrylic ester polymer such as poly(methylmethacrylate), and a fluorescent colorant selected from the group consisting of a dye, a pigment and a quantum dot.

However, there is still the need in the art for a luminescent solar concentrator advantageously exhibiting enhanced durability and weatherability properties in the long term over conventional luminescent solar concentrators, while maintaining outstanding mechanical and optical properties.

### Summary of invention

It has been now found that a collector for a luminescent solar concentrator is advantageously easily obtainable by processing a thermoplastic fluoropolymer composition comprising at least one thermoplastic partially fluorinated polymer, at least one polyacrylate and at least one luminescent compound.

The collector of the present invention advantageously shows outstanding optical transparency and haze properties while successfully exhibiting reduced waveguide losses and thus enhanced optical efficiency in the long term.

Also, the collector of the present invention advantageously shows outstanding interlayer adhesion properties and good mechanical properties to be suitably used in a luminescent solar concentrator.

In a first instance, the present invention pertains to a collector comprising at least one front layer [layer (F)] made of a composition [composition (C)] comprising at least one thermoplastic partially fluorinated polymer [polymer (F)], at least one polyacrylate [polyacrylate (A)] and at least one luminescent compound [compound (L)].

The collector of the invention is particularly suitable for use in a luminescent solar concentrator.

The layer (F) is typically the outer layer of the collector receiving incident electromagnetic radiation.

The collector may further comprise at least one back layer [layer (B)].

For the purpose of the present invention, the term "back layer [layer (B)]" is intended to denote the inner layer of the collector.

Should the collector further comprise at least one layer (B), said at least one layer (B) is typically adhered to at least one layer (F).

The layer (B) is preferably made of either glass or of a composition comprising at least one thermoplastic polymer. The thermoplastic polymer may be a thermoplastic polymer (F).

Should the collector further comprise at least one layer (B), it may also further comprise at least one adhesive layer [layer (A1)] between at least one layer (F) and at least one layer (B).

The nature of the material constituting the layer (A1) is not particularly limited provided that said layer (A1) ensures improved adhesion between the layer (F) and the layer (B) of the collector.

The layer (A1) is typically made of at least one polymer such as a thermoplastic polymer.

The collector preferably consists of:

- at least one layer (F),
- optionally, at least one layer (B), and
- optionally, between said at least one layer (F) and said at least one layer (B), at least one layer (A1).

Should the collector further comprise at least one layer (B), the layer (F) of the collector of the invention typically has a thickness of from 0.01 mm to 1 mm, preferably of from 0.01 mm to 0.5 mm.

Should the collector be free from at least one layer (B), the layer (F) of the collector of the invention typically has a thickness of from 0.01 mm to 100 mm, preferably of from 0.01 mm to 10 mm.

The collector is typically optically transparent.

For the purpose of the present invention, the term "optically transparent" is understood to mean that incident electromagnetic radiation is allowed to pass through a material without being scattered or absorbed.

The collector of the invention is advantageously optically transparent to incident electromagnetic radiation having a wavelength of from about 200 nm to about 2500 nm, preferably of from about 400 nm to about 800 nm.

The collector preferably has a total transmittance of more than 80%, preferably of more than 85%, more preferably of more than 90%, as measured on a collector having a thickness of about 50 μm according to ASTM D1003 in air.

Further, the collector preferably has values of Haze of less than 15%, preferably of less than 10%, more preferably of less than 7%, as measured on a collector having a thickness of about 50 μm according to ASTM D1003 in air.

The layer (F) typically has a refractive index $n_1$ comprised between 1 and 2.

The layer (B) typically has a refractive index $n_2$ comprised between 1 and 2.

The layer (B) preferably has a refractive index $n_2$ higher than the refractive index $n_1$ of the layer (F).

The layer (A1) typically has a refractive index $n_3$ comprised between 1 and 2.

The collector typically has a refractive index $n_4$ comprised between 1 and 2.

The refractive index can be measured according to any suitable method.

In a second instance, the present invention pertains to a luminescent solar concentrator comprising at least one collector and at least one photovoltaic cell.

The collector of the luminescent solar concentrator of the invention is advantageously the collector of the present invention.

At least one photovoltaic cell of the luminescent solar concentrator of the invention is typically adhered to at least a portion of the collector.

The photovoltaic cell is preferably adhered to at least a portion of the collector by means of at least one adhesive layer [layer (A2)].

The layer (A2) typically has a refractive index $n_5$ comprised between 1 and 2.

The layer (A2) typically has a refractive index $n_5$ substantially equal to the refractive index $n_4$ of the collector.

The layer (A2), equal to or different from the layer (A1), is typically made of at least one polymer such as a thermoplastic polymer.

The layer (A2) is usually made of a polyurethane polymer.

The photovoltaic cell typically has an absorption surface receiving electromagnetic radiation emitted by the collector.

According to a first embodiment of the invention, the plane of the absorption surface of at least one photovoltaic cell of the luminescent solar concentrator is substantially parallel to the plane of the layer (F) of at least one collector.

The collector of this first embodiment of the invention typically has a thickness of from 0.01 mm to 1 mm, preferably of from 0.01 mm to 0.5 mm.

According to a second embodiment of the invention, the plane of the absorption surface of at least one photovoltaic cell of the luminescent solar concentrator is substantially perpendicular to the plane of the layer (F) of at least one collector.

The collector of this second embodiment of the invention typically has a thickness of from 0.01 mm to 100 mm, preferably of from 0.01 mm to 10 mm.

The skilled in the art will select the proper thickness of the collector having regard to the configuration of the luminescent solar concentrator according to either the first or the second embodiment of the invention.

The photovoltaic cell typically comprises at least one semiconductor photoactive layer.

For the purpose of the present invention, the term "semiconductor photoactive layer" is intended to denote a layer endowed with photoelectric conversion property and able to perform photovoltaic conversion. The specific materials used for forming such semiconductor photoactive layer include single crystal silicon semiconductor, non-single crystal silicon semiconductor (e.g. an amorphous silicon (a-Si) semiconductor or a polycrystalline silicon semiconductor), compound semiconductors and junctions such as $CuInSe_2$, $CuInS_2$, GaAs, CdS/$Cu_2S$, CdS/CdTe, CdS/InP, and CdTe/$Cu_2Te$, and organic semiconductors such as polymers and small-molecule compounds like polyphenylene vinylene, copper phthalocyanine (a blue or green organic pigment) and carbon fullerenes.

The semiconductor photoactive layer formed of either of the above semiconductor is typically either a "pn junction" or a "pin junction" or a Schottky junction.

The photovoltaic cell may further comprise at least one optically transparent electroconductive layer.

For the purpose of the present invention, the term "electroconductive layer" is intended to denote an upper-side electrode (i.e. an electrode having a light receiving surface). Specific examples of materials suitable for use in the

optically transparent electroconductive layer include $In_2O_3$, $SnO_2$, $In_2O_3$-$SnO_2$ (ITO), ZnO, $TiO_2$, $Cd_2SnO_4$, crystalline semiconductor layers doped with a high concentration of an impurity, like notably fluorine-doped tin oxide ($SnO_2$:F, or "FTO"), doped zinc oxide (e.g. : ZnO:Al) and flexible organic conductors, like, e.g. carbon nanotube networks embedded in a transparent polymer matrix.

The layer may be formed by resistance-heating vapor deposition, sputtering, spraying, chemical vapour deposition (CVD), impurity diffusion, and like methods. In case of flexible organic conductors, typical polymer processing technologies are also available, including laminating, casting, extrusion and the like.

A grid-type collecting electrode may be provided on the optically transparent electroconductive layer in order to efficiently collect the generated current. Specific examples of materials suitable for use in the collecting electrode include Ti, Cr, Mo, W, Al, Ag, Ni, Cu, Sn, and alloys thereof, and an electroconductive paste such as a silver paste. The collecting electrode may be formed by sputtering, resistance heating, and CVD employing a mask pattern; metal film deposition and subsequent etching for patterning; direct grid electrode pattern formation by photo-assisted CVD; formation of a negative pattern mask of the grid electrode and subsequent metal plating; printing with electroconductive paste, bonding of metal wires, and like methods. The electroconductive paste generally includes a dispersion of powder of silver, gold, copper, nickel, carbon or the like in a polymeric binder. The polymeric binder includes polyester resins, epoxy resins, acrylic resins, alkyd resins, polyvinyl acetate resins, rubbers, urethane resins, and phenol resins. Otherwise, a wire made of a metal such as Cu may be provided on the transparent conductive layer.

The photovoltaic cell may also further comprise at least one electroconductive substrate.

For the purpose of the present invention, the term "electroconductive substrate" is intended to denote a base member for the photovoltaic cell as well as a lower-side electrode. Examples of materials thereof include silicon, tantalum, molybdenum, tungsten, stainless steel, aluminium, copper, titanium, carbon sheet, lead-plated steel, and resin films, and ceramics and glass having an electroconductive layer formed thereon. On the above electroconductive substrate, a backside reflection layer may be formed from a metal layer, a metal oxide layer, or a lamination thereof. The metal layer can be formed from Ti, Cr, Mo, W, Al, Ag, Ni, Cu, and the like. The metal oxide layer can be formed from ZnO, $TiO_2$, $SnO_2$, $In_2O_3$ -$SnO_2$ (ITO), and the like. The metal layer and the metal oxide layer may be formed by resistance heating vapor deposition, electron beam vapor deposition, sputtering, or like method.

The luminescent solar concentrator is generally equipped with output terminals for extracting photovoltaic current. The output terminals are typically in electric connection with the electroconductive substrate and the collecting electrode, respectively. A metal piece such as a copper tab can be used as output terminal at the electroconductive substrate side, connected to the electroconductive substrate by spot welding or soldering. On the other hand, a metal may be electrically connected to the collecting electrode by means of conductive paste or solder.

For the purpose of the present invention, the term "thermoplastic" is understood to mean linear polymers existing, at room temperature, below their glass transition temperature, if they are amorphous, or below their melting point, if they are semi-crystalline. These polymers have the property of becoming soft when they are heated and of becoming rigid again when they are cooled, without there being an appreciable chemical change. Such a definition may be found, for example, in the encyclopaedia called Polymer Science Dictionary. Edited by MARK S.M. ALGER. LONDON: ELSEVIER APPLIED SCIENCE, 1989. p.476.

For the purpose of the present invention, the term "partially fluorinated fluoropolymer [polymer (F)]" is intended to denote a polymer comprising, preferably consisting of, recurring units derived from at least one fluorinated monomer [monomer (F)] and, optionally, at least one hydrogenated monomer [monomer (H)], provided that said recurring units comprise at least one hydrogen atom derived from either at least one monomer (F) or at least one monomer (H).

By the term "fluorinated monomer [monomer (F)]" it is hereby intended to denote an ethylenically unsaturated monomer comprising at least one fluorine atom and, optionally, at least one hydrogen atom.

By the term "hydrogenated monomer [monomer (H)]" it is hereby intended to denote an ethylenically unsaturated monomer comprising at least one hydrogen atom and free from fluorine atoms.

The term "at least one fluorinated monomer" is understood to mean that the polymer (F) may comprise recurring units derived from one or more than one fluorinated monomers. In the rest of the text, the expression "fluorinated monomers" is understood, for the purposes of the present invention, both in the plural and the singular, that is to say that they denote both one or more than one fluorinated monomers as defined above.

The term "at least one hydrogenated monomer" is understood to mean that the polymer (F) may comprise recurring units derived from one or more than one hydrogenated monomers. In the rest of the text, the expression "hydrogenated monomers" is understood, for the purposes of the present invention, both in the plural and the singular, that is to say that they denote both one or more than one hydrogenated monomers as defined above.

The polymer (F) is typically obtainable by polymerization of at least one fluorinated monomer [monomer (F)] and, optionally, at least one hydrogenated monomer [monomer (H)].

Non limitative examples of suitable monomers (F) include, notably, the followings:

- $C_2$-$C_8$ perfluoroolefins such as tetrafluoroethylene and hexafluoropropylene;

- $C_2$-$C_8$ hydrogenated fluoroolefins such as vinylidene fluoride, vinyl fluoride, 1,2-difluoroethylene and trifluoroethylene;
- perfluoroalkylethylenes of formula $CH_2$=CH-$R_{f0}$ wherein $R_{f0}$ is a $C_1$-$C_6$ perfluoroalkyl;
- chloro- and/or bromo- and/or iodo-$C_2$-$C_6$ fluoroolefins such as chlorotrifluoroethylene;
- (per)fluoroalkylvinylethers of formula $CF_2$=$CFOR_{f1}$ wherein $R_{f1}$ is a $C_1$-$C_6$ fluoro- or perfluoroalkyl, e.g. $CF_3$, $C_2F_5$, $C_3F_7$ ;
- $CF_2$=$CFOX_0$ (per)fluoro-oxyalkylvinylethers wherein $X_0$ is a $C_1$-$C_{12}$ alkyl group, a $C_1$-$C_{12}$ oxyalkyl group or a $C_1$-$C_{12}$ (per)fluorooxyalkyl group having one or more ether groups, such as perfluoro-2-propoxy-propyl group;
- (per)fluoroalkylvinylethers of formula $CF_2$=$CFOCF_2OR_{f2}$ wherein $R_{f2}$ is a $C_1$-$C_6$ fluoro- or perfluoroalkyl group, e.g. $CF_3$, $C_2F_5$, $C_3F_7$ or a $C_1$-$C_6$ (per)fluorooxyalkyl group having one or more ether groups such as -$C_2F_5$ -O-$CF_3$;
- functional (per)fluoro-oxyalkylvinylethers of formula $CF_2$=$CFOY_0$ wherein $Y_0$ is a $C_1$-$C_{12}$ alkyl group or (per)fluoroalkyl group, a $C_1$-$C_{12}$ oxyalkyl group or a $C_1$-$C_{12}$ (per)fluorooxyalkyl group having one or more ether groups and $Y_0$ comprising a carboxylic or sulfonic acid group, in its acid, acid halide or salt form;
- fluorodioxoles, preferably perfluorodioxoles.

Should the monomer (F) comprise at least one hydrogen atom, it is designated as hydrogen-containing fluorinated monomer [monomer (FH)].
The monomer (F) may further comprise one or more other halogen atoms (Cl, Br, I).
Should the monomer (F) be free of hydrogen atoms, it is designated as per(halo)fluorinated monomer [monomer (FX)].
Should the monomer (F) be a hydrogen-containing fluorinated monomer [monomer (FH)], such as for instance vinylidene fluoride, trifluoroethylene or vinyl fluoride, the polymer (F) is either a polymer comprising recurring units derived from at least one monomer (FH) and, optionally, at least one monomer (F) different from said monomer (FH) or it is a polymer comprising recurring units derived from at least one monomer (FH), optionally, at least one monomer (F) different from said monomer (FH) and, optionally, at least one monomer (H).
Should the monomer (F) be a per(halo)fluorinated monomer [monomer (FX)], such as for instance tetrafluoroethylene, chlorotrifluoroethylene, hexafluoropropylene, perfluoroalkylvinylethers, the polymer (F) is a polymer comprising recurring units derived from at least one monomer (FX), at least one monomer (H) and, optionally, at least one monomer (F) different from said monomer (FX).
The polymer (F) may be amorphous or semi-crystalline.
The term "amorphous" is hereby intended to denote a polymer (F) having a heat of fusion of less than 5 J/g, preferably of less than 3 J/g, more preferably of less than 2 J/g, as measured according to ASTM D-3418-08.
The term "semi-crystalline" is hereby intended to denote a polymer (F) having a heat of fusion of from 10 to 90 J/g, preferably of from 15 to 80 J/g, more preferably of from 20 to 70 J/g, as measured according to ASTM D3418-08.
The polymer (F) is preferably selected from the group consisting of:

- polymers (F-1) comprising recurring units derived from vinylidene fluoride (VDF) and, optionally, at least one monomer (F) different from VDF, and
- polymers (F-2) comprising recurring units derived from at least one monomer (FX) selected from tetrafluoroethylene (TFE) and chlorotrifluoroethylene (CTFE), at least one monomer (H) selected from ethylene (E), propylene and isobutylene and, optionally, at least one monomer (F) different from said monomer (FX), typically in an amount of from 0.01% to 30% by moles, based on the total amount of TFE and/or CTFE and said monomer (H).

The polymer (F-1) preferably comprises:

(a) at least 60% by moles, preferably at least 70% by moles, more preferably at least 80% by moles of vinylidene fluoride (VDF), and
(b) optionally, from 0.1 % to 40% by moles, preferably from 0.1 % to 30% by moles, more preferably from 0.1 % to 20% by moles, based on the total amount of monomers (a) and (b), of at least one monomer (F) selected from the group consisting of vinyl fluoride ($VF_1$), chlorotrifluoroethylene (CTFE), hexafluoropropylene (HFP), tetrafluoroethylene (TFE), trifluoroethylene (TrFE) and perfluoromethylvinylether (PMVE).

The polymer (F-1) may further comprise from 0.1 % to 5% by moles, preferably from 0.1 % to 3% by moles, more preferably from 0.1 % to 1% by moles, based on the total amount of monomers (a) and (b), of at least one monomer (H).
The polymer (F-1) is preferably selected from the group consisting of homopolymers of VDF, VDF/TFE copolymers, VDF/TFE/HFP copolymers, VDF/TFE/CTFE copolymers, VDF/TFE/TrFE copolymers, VDF/CTFE copolymers, VDF/HFP copolymers, VDF/TFE/HFP/CTFE copolymers, VDF/TFE/perfluorobutenoic acid copolymers,

VDF/TFE/maleic acid copolymers and the like.

The polymer (F-1) is more preferably selected from the group consisting of homopolymers of VDF and copolymers of VDF with 0.1 % to 10% by moles of a fluorinated comonomer selected from the group consisting of chlorotrifluoroethylene (CTFE), hexafluoropropene (HFP), tetrafluoroethylene (TFE), trifluoroethylene (TrFE) and mixtures thereof.

The polymer (F-1) typically has a melting point of at least 120°C, preferably of at least 135°C, more preferably of at least 150°C.

The polymer (F-1) typically has a melting point of at most 190°C, preferably of at most 185°C, more preferably of at most 180°C.

The melting point was measured by Differential Scanning Calorimetry (DSC), at a heating rate of 10°C/min, according to ASTM D 3418.

The polymer (F-1) typically has a heat of fusion of at least 10 J/g, preferably of at least 20 J/g.

The polymer (F-1) typically has a heat of fusion of at most 70 J/g, preferably of at most 40 J/g, more preferably of at most 30 J/g.

The heat of fusion was measured by Differential Scanning Calorimetry (DSC), at a heating rate of 10°C/min, according to ASTM D 3418.

Polymers (F-2) wherein the monomer (FX) is chlorotrifluoroethylene (CTFE) will be identified herein below as ECTFE copolymers; polymers (F-2) wherein the monomer (FX) is tetrafluoroethylene (TFE) will be identified herein below as ETFE copolymers.

The polymer (F-2) preferably comprises:

(a') from 10% to 90% by moles, preferably from 30% to 70% by moles of at least one monomer (FX) selected from the group consisting of chlorotrifluoroethylene (CTFE) and tetrafluoroethylene (TFE), and
(b') from 10% to 90% by moles, preferably from 30% to 70% by moles, based on the total amount of monomers (a') and (b'), of ethylene (E).

The polymer (F-2) more preferably comprises, even more preferably consists of:

(a') from 50% to 70% by moles, preferably from 53% to 65% by moles of at least one monomer (FX) selected from the group consisting of chlorotrifluoroethylene (CTFE) and tetrafluoroethylene (TFE), and
(b') from 30% to 50% by moles, preferably from 35% to 47% by moles, based on the total amount of monomers (a') and (b'), of ethylene (E).

The polymer (F-2) may further comprise from 0.1 % to 30% by moles, preferably from 0.1 % to 15% by moles, more preferably from 0.1 % to 10% by moles, based on the total amount of monomers (a') and (b'), of at least one other monomer selected from the group consisting of monomers (F) and monomers (H).

Non-limiting examples of monomers (F) suitable for polymers (F-2) include, notably, monomers (F) selected from the group consisting of perfluoroalkylvinylethers, perfluoroalkylethylenes such as perfluorobutylethylene, perfluorodioxoles and vinylidene fluoride. Among them, the preferred monomer (F) is perfluoropropylvinylether of formula $CF_2=CFO-C_3F_7$.

Non-limiting examples of monomers (H) suitable for polymers (F-2) include, notably, monomers (H) of formula (H-1):

$$CH_2=CH-(CH_2)_nR_1 \quad (H-1)$$

wherein:

- $R_1$ is a $-OR_2$ or a $-(O)_tCO(O)_pR_2$ group, wherein t and p are integers equal to 0 or 1,
- $R_2$ is a hydrogen atom or a hydrogenated linear or branched alkyl or cycloalkyl group having from 1 to 20 carbon atoms, optionally containing heteroatoms and/or chlorine atoms, the heteroatoms preferably being O or N, and
- n is an integer in the range of from 0 to 10.

In formula (H-1), $R_2$ optionally contains one or more functional groups, preferably selected from the group consisting of OH, COOH, epoxide, ester and ether groups. $R_2$ may optionally contain double bonds.

In formula (H-1), $R_2$ is preferably an alkyl group having from 1 to 10 carbon atoms containing hydroxyl functional groups and n is an integer in the range of from 0 to 5.

Preferred monomers (H) suitable for polymers (F-2) are selected from the group consisting of monomers (H) of either of formulae (H-2) to (H-5):

- acrylic monomers of formula (H-2):

$$CH_2=CH-CO-O-R_2 \text{ (H-2)}$$

such as ethylacrylate, n-butylacrylate, acrylic acid and hydroxyalkylacrylates such as hydroxyethylacrylate, hydroxypropylacrylate and (hydroxy)ethylhexylacrylate,
- vinylether monomers of formula (H-3):

$$CH_2=CH-O-R_2 \text{ (H-3)}$$

such as propylvinylether, cyclohexylvinylether and 4-hydroxybutylvinylether,
- vinyl monomers of the carboxylic acid of formula (H-4):

$$CH_2=CH-O-CO-R_2 \text{ (H-4)}$$

such as vinyl acetate, vinyl propionate and vinyl-2-ethylhexanoate, and - unsaturated carboxylic acid monomers of formula (H-5): $CH_2=CH-(CH_2)_n$ -COOH (H-5)

wherein n has the above mentioned meaning such as vinylacetic acid.

Most preferred monomers (H) suitable for polymers (F-2) are selected from the group consisting of the acrylic monomers of formula (H-2) as defined above.

Nevertheless, ECTFE polymers free from other monomers are preferred.

End chains, defects or minor amounts of monomer impurities leading to recurring units different from those above mentioned can be still comprised in the preferred ECTFE, without affecting properties of the material.

The polymer (F-2) typically has a melting point of at least 120°C, preferably of at least 130°C, more preferably of at least 140°C, even more preferably of at least 150°C.

The polymer (F-2) typically has a melting point of at most 210°C, preferably of at most 200°C, more preferably of at most 195°C, even more preferably of at most 190°C.

The melting point was measured by Differential Scanning Calorimetry (DSC), at a heating rate of 10°C/min, according to ASTM D 3418.

The polymer (F-2) typically has a heat of fusion of at least 1 J/g, preferably of at least 2 J/g, more preferably of at least 5 J/g.

The polymer (F-2) typically has a heat of fusion of at most 35 J/g, preferably of at most 30 J/g, more preferably of at most 25 J/g.

The heat of fusion was measured by Differential Scanning Calorimetry (DSC), at a heating rate of 10°C/min, according to ASTM D 3418.

The polymer (F-2) typically has a melt flow rate of from 0.01 to 75 g/10 min, preferably of from 0.1 to 50 g/10 min, more preferably of from 0.5 to 30 g/10 min.

The melt flow rate was measured according to ASTM 3275-81 at 230°C and 2.16 Kg.

The polyacrylate (A) is typically a polymer comprising, preferably consisting of, recurring units derived at least one monomer (H) comprising at least one carboxylic acid ester group of formula -COOM, wherein M is a $C_1$-$C_5$ alkyl group.

The polyacrylate (A) is preferably of formula (A-1):

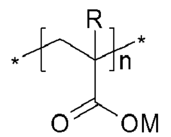

(A-1)

wherein M is a $C_1$-$C_5$ alkyl group, R is H or $-CH_3$ and n is an integer such that the number average molecular weight of the polyacrylate (A) is of from 1000 to 1000000, preferably of from 2000 to 100000, more preferably of from 3000 to 60000.

The polyacrylate (A) typically has a polydispersity index comprised between 1 and 3, preferably between 1.5 and 2.5.

The polyacrylate (A) is more preferably selected from the group consisting of:

- polyacrylic acid esters having a molecular weight of from about 5000 to about 1000000,
- polymethacrylic acid esters having a molecular weight of from about 2000 to about 500000, and

- polymethylmethacrylic acid esters having a molecular weight of from about 1000 to about 100000.

For the purpose of the present invention, the term "luminescent compound [compound (L)]" is intended to denote either a fluorescent compound [compound (L-F)] or a phosphorescent compound [compound (L-P)].
The terms "luminescent", "fluorescent" and "phosphorescent" are used in the present invention according to their usual meanings.
The compound (L) is usually able to re-emit the absorbed electromagnetic radiation from an excited state to a ground state.
The choice of the compound (L) is not particularly limited.
The compound (L) is typically selected from the group consisting of organic compounds (L-O) and inorganic compounds (L-I).
Mixtures of one or more organic compounds (L-O) and one or more inorganic compounds (L-I) may be used in the composition (C) of the collector of the invention. Otherwise organic compounds (L-O) or inorganic compounds (L-I) may be separately used.
Non-limiting examples of organic compounds (L-O) typically include polycyclic aromatic compounds.
The organic compound (L-O) is preferably of formula (L-1):

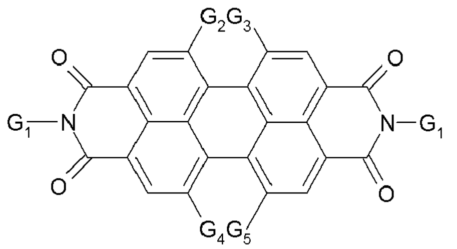

(L-1)

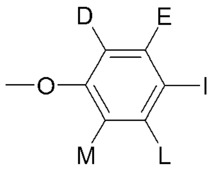

(X)

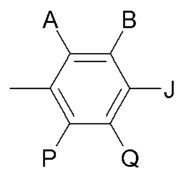

(Y)

wherein:

- $G_1$ is a linear or branched alkyl group or oxygen-containing alkyl group of formula $C_nH_{2n+1}O_m$, wherein n is an integer of from 1 to 44 and m is lower than n/2, or a group Y, wherein each of A, B, P, J and Q is independently a hydrogen atom, a fluorine atom, a methoxy group or a $C_nH_{2n+1}$ alkyl group, wherein n is an integer from 1 to 16,
- each of $G_2$, $G_3$, $G_4$ and $G_5$ is independently a hydrogen atom, a fluorine atom, a methoxy group, a $C_nH_{2n+1}$ alkyl group, wherein n is an integer from 1 to 16, or a group X, wherein each of D, E, I, L and M is independently a hydrogen atom, a fluorine atom, a methoxy group or a $C_n H_{2n+1}$ alkyl group, wherein n is an integer from 1 to 16.

According to an embodiment of the invention, $G_1$ in formula (L-1) is a group Y. Preferably, when $G_1$ in formula (L-1) is a group Y, each of $G_2$, $G_3$ , $G_4$ and $G_5$ is a group X, each of A and P is a isopropyl group and each of B, J, D, E, I, L and M is a hydrogen atom.
Organic compounds (L-O) of formula (L-1) suitable for use in the composition (C) of the collector of the invention are typically commercially available under the trademark name LUMOGEN® F Red 305.
Non-limiting examples of inorganic compounds (L-I) typically include inorganic compounds comprising at least one element selected from the group consisting of rare earth metals, Zn and Mn.
It has been surprisingly found that the composition (C) significantly contributes increasing the optical efficiency of the luminescent solar concentrator of the invention.
It has been also surprisingly found that the composition (C) significantly contributes improving durability and weatherability properties of the collector in the luminescent solar concentrator of the invention.
The composition (C) typically comprises:

- from 5% to 90% by weight of at least one thermoplastic polymer (F),
- from 5% to 85% by weight of at least one polyacrylate (A), and
- from 0.1% to 10% by weight of at least one compound (L).

The composition (C) preferably comprises:

- from 20% to 85% by weight of at least one thermoplastic polymer (F),
- from 10% to 75% by weight of at least one polyacrylate (A), and
- from 0.1 % to 5% by weight of at least one compound (L).

The composition (C) more preferably comprises:

- from 50% to 80% by weight of at least one thermoplastic polymer (F),
- from 15% to 45% by weight of at least one polyacrylate (A), and
- from 0.1 % to 5% by weight of at least one compound (L).

The composition (C) may further comprise one or more additives selected from the group consisting of UV blockers, fillers, lubricating agents, heat stabilizers, anti-static agents, acid scavengers, flame-retardants, smoke-suppressing agents and the like.

The composition (C) may preferably further comprise at least one metal or semi-metal compound in the form of nanoparticles.

The selection of the UV blockers is not particularly limited; both organic and inorganic compounds may be used. Preferred UV blockers are notably based on $CeO_2$, ZnO and/or $TiO_2$. Nanoparticles of ZnO and/or $TiO_2$, possibly coated with coupling agents such as silane coupling agents, may also be used.

In a third instance, the present invention pertains to a process for the manufacture of a collector, said process comprising:

(i) providing a composition (C) as defined above, and
(ii) processing into a layer the composition (C) provided in step (i).

The collector obtainable by the process of the invention is advantageously the collector of the present invention.

According to a first embodiment of the invention, under step (i) of the process of the invention, the composition (C) further comprises at least one organic solvent.

The process for the manufacture of a collector of this first embodiment of the invention typically comprises:

(i) providing a composition (C) further comprising at least one organic solvent,
(ii) processing into a layer the composition (C) provided in step (i), and
(iii) drying the layer provided in step (ii).

Non-limiting examples of organic solvents suitable in the process of the invention are selected from the group consisting of:

- aliphatic, cycloaliphatic or aromatic ether oxides, more particularly, diethyl oxide, dipropyl oxide, diisopropyl oxide, dibutyl oxide, methyltertiobutylether, dipentyl oxide, diisopentyl oxide, ethylene glycol dimethyl ether, ethylene glycol diethyl ether, ethylene glycol dibutyl ether benzyl oxide; dioxane, tetrahydrofuran,
- glycol ethers such as ethylene glycol monomethyl ether, ethylene glycol monoethyl ether, ethylene glycol monopropyl ether, ethylene glycol monoisopropyl ether, ethylene glycol monobutyl ether, ethylene glycol monophenyl ether, ethylene glycol monobenzyl ether, diethylene glycol monomethyl ether, diethylene glycol monoethyl ether, diethylene glycol mono-n-butyl ether,
- glycol ether esters such as ethylene glycol methyl ether acetate, ethylene glycol monoethyl ether acetate, ethylene glycol monobutyl ether acetate,
- alcohols such as methyl alcohol, ethyl alcohol, diacetone alcohol,
- ketones such as acetone, methylethylketone, methylisobutyl ketone, diisobutylketone, cyclohexanone, isophorone, and
- linear or cyclic esters such as isopropyl acetate, n-butyl acetate, methyl acetoacetate, dimethyl phthalate, $\gamma$-butyrolactone;
- linear or cyclic amides such as N,N-diethylacetamide, N,N-dimethylacetamide, dimethylformamide and N-methyl-2-pyrrolidone; and
- dimethyl sulfoxide.

Under step (i) of the process of this first embodiment of the invention, the composition (C) is typically obtainable by dissolving at least one compound (L) in a blend obtainable by mixing a liquid composition comprising at least one

thermoplastic polymer (F) and at least one organic solvent and a liquid composition comprising at least one polyacrylate (A) and at least one organic solvent.

Under step (ii) of the process of this first embodiment of the invention, the composition (C) is typically processed into a layer in liquid phase.

One or more techniques generally known in the art are typically used for processing the composition (C) into a layer in liquid phase such as spin coating, casting, doctor blade, roller, ink jet and spraying.

Under step (iii) of the process of this first embodiment of the invention, drying can be performed either under atmospheric pressure or under vacuum. Alternatively, drying can be performed under modified atmosphere, e.g. under an inert gas, typically exempt notably from moisture (water vapour content of less than 0.001% v/v).

The drying temperature will be selected so as to effect removal by evaporation of one or more organic solvents, if any, from the collector of the invention.

Under step (iii) of the process of this first embodiment of the invention, the layer provided in step (ii) is typically dried at a temperature usually comprised between 25°C and 200°C.

The layer provided in step (iii) of the process of this first embodiment of the invention is advantageously the layer (F) of the collector of the present invention.

According to a first variant of the process of the first embodiment of the invention, the layer provided in step (iii) may be adhered to a layer (B), optionally through at least one layer (A1).

According to a second variant of the process of the first embodiment of the invention, under step (ii), the composition (C) may be applied onto a layer (B) and then processed into a layer in liquid phase.

According to this second variant of the process of the first embodiment of the invention, the composition (C) is typically applied onto a layer (B) and then processed into a layer by spin coating. The skilled in the art will select proper spin coating process parameters having regard to the nature of the composition (C) and the layer (B).

The layer provided in step (iii) of the process of this second variant of the first embodiment of the invention is typically adhered to the layer (B).

According to a second embodiment of the invention, under step (i) of the process of the invention, the composition (C) is free from one or more organic solvents.

Under step (ii) of the process of this second embodiment of the invention, the composition (C) is typically processed into a layer in molten phase.

One or more techniques generally known in the art are typically used for processing the composition (C) into a layer in molten phase such as extrusion and moulding.

Under step (ii) of the process of this second embodiment of the invention, the composition (C) is typically processed in molten phase at a temperature generally comprised between 100°C and 300°C, preferably between 150°C and 250°C, as a function of the melting point of the thermoplastic polymer (F). The composition (C) is typically obtained in the form of pellets. Layers can then be manufactured by processing the pellets so obtained through conventional extrusion techniques or moulding techniques.

The layer provided in step (ii) of the process of this second embodiment of the invention is advantageously the layer (F) of the collector of the present invention.

According to a first variant of the process of the second embodiment of the invention, the layer provided in step (ii) may be adhered to a layer (B), optionally through at least one layer (A1).

According to a second variant of the process of the second embodiment of the invention, under step (ii), the composition (C) may be applied onto a layer (B) and then processed into a layer in molten phase.

The layer provided in step (iii) of the process of this second variant of the second embodiment of the invention is typically adhered to the layer (B).

In a fourth instance, the present invention pertains to a process for the manufacture of a luminescent solar concentrator, said process comprising bonding at least a portion of at least one collector with at least one photovoltaic cell.

The luminescent solar concentrator obtainable by the process of the invention is advantageously the luminescent solar concentrator of the present invention.

The process of the invention typically comprises bonding at least a portion of the layer (F) of at least one collector with at least one photovoltaic cell.

Should the collector further comprise at least one layer (B), the process of the invention typically comprises bonding at least a portion of the layer (B) of at least one collector with at least one photovoltaic cell.

Bonding is commonly obtainable by means of at least one layer (A2).

The invention will be now described in more detail with reference to the following examples whose purpose is merely illustrative and not limitative of the scope of the invention.

## Raw materials

Polymers (F): SOLEF® 6010 PVDF homopolymer, SOLEF® 31508

VDF/CTFE copolymer (15% by weight CTFE), VDF/HFP/HEA terpolymer (0.8% mol HEA, 2.3% mol HFP).
Polyacrylate (A): poly(methylmethacrylate) having a number average molecular weight of 50000 and a polydispersity index of 2.
Compound (L): LUMOGEN® F Red 305 from BASF.

## Device fabrication

All the LSC devices were fabricated onto transparent glass substrates having a thickness of 1.8 mm with different top surface areas (50 mm x 25 mm, 25 mm x 25 mm). Polymers (F) in powder form were dissolved in 1-methyl-2-pyrrolidone (NMP) (90-100°C) at concentrations between 5% and 20% by weight and the solutions were maintained under magnetic stirring overnight. For blends, a solution of poly(methylmethacrylate) (PMMA) in hot toluene (100°C) was also prepared at concentrations between 5% and 20% by weight and allowed to magnetically stir overnight. The compound (L) was dissolved in the hot PMMA solution at different concentrations (0.01-10% by weight). The blends were prepared by mixing the PMMA solution with the polymer (F) solution in different polymer (F):PMMA weight ratios (from 50:50 to 90:10) and by adding the desired amount of the solution of the compound (L). Each final solution was deposited onto the transparent glass substrate by spin coating (spin coating speed: 1200-300 rpm, spin coating time: 40 s) and the film was thermally post-processed at 220°C in a ventilated oven for 5 minutes to allow for solvent evaporation. The so-formed coatings were then coupled to one or more multicrystalline-Si photovoltaic (PV) cells so that one or more edges of the glass substrate were connected to the photoactive area of one or more PV cells. Bonding was performed by means of a hot-melt thermosoftening polyurethane adhesive (but also other index-matching optically clear bonding media can be used) that was placed on the photoactive face of the PV cell after positioning the PV cell face-up on a 140°C hot-plate. Once softening of the polyurethane film was achieved (approximately 2 minutes at 140°C), each edge of the LSC glass substrate was pressed onto the adhesive film for about 30 seconds to ensure a good optical contact with the PV cell. The LSC system was then allowed to cool down to room temperature so that hardening of the polyurethane could be achieved.

## Weathering tests

The LSC devices were subjected to weathering tests under continuous Xenon light illumination in a weather-o-meter chamber (Solarbox 3000e, Cofomegra S.r.l.) equipped with an outdoor filter cutting all wavelengths below 280 nm, according to ISO 11341:2004(E). The total irradiance during the weathering test was approximately 100 mW $cm^{-2}$ (55 mW $cm^{-2}$ in the 300-800 nm wavelength range), as measured by means of a power-meter with a thermopile sensor (Ophir). The UV-light irradiance level in the 295-400 nm range was 5 mW $cm^{-2}$, as measured by means of a UV-photodiode. The relative humidity and the working temperature inside the testing chamber were constant and measured to be 20% and 38°C, respectively. The LSC devices were periodically taken out of the weather-o-meter chamber for PV characterization, as described in the next section.

## Measurement protocol

For the PV characterization of the illuminated LSC devices, current-voltage (I-V) curves have been collected by means of a source-measure unit under AM 1.5G solar illumination at 100 mW $cm^{-2}$ (1 sun), calibrated with a NREL certified reference cell. I-V testing has been carried-out in air by performing scans between - 0.2 V and 0.6 V with 10 mV step intervals on the illuminated LSC device and by recording the current response. The solar simulator power output was monitored by means of a power-meter with a thermopile sensor.

## Performance evaluation

The power conversion efficiency of the LSC device [$\eta_{LSC}$] was measured according to the following equation:

$$\eta_{LSC} = [FF \times (I_{SC}/A_{LSC}) \times V_{OC}]/P_{IN}$$

wherein FF (-) is the fill factor, $I_{SC}$ [mA] is the short circuit current and $V_{OC}$ [V] is the open circuit voltage extracted from the PV cells attached to the LSC waveguide, $A_{LSC}$ [$cm^2$] is the area of the LSC top surface, and $P_{IN}$ [mW $cm^{-2}$] is the incident solar power density.
The optical efficiency of the LSC device [$\eta_{opt}$] was measured according to the following equation:

$$\eta_{opt} = \eta_{LSC}/\eta_{PV}$$

wherein $\eta_{PV}$ is the power conversion efficiency of the bare PV cell under front face direct illumination.

## EXAMPLES

### Example 1 - Adhesion in polymer (F):PMMA blend LSC devices

A solution of SOLEF® 31508 VDF-CTFE copolymer in NMP (20% by weight) was mixed with a solution of PMMA in toluene containing 5% by weight of LUMOGEN® F Red 305 luminescent compound to obtain a P(VDF-CTFE):PMMA weight ratio of 70:30. The adhesion of the P(VDF-CTFE)/PMMA polymeric coating on the glass substrate was evaluated by means of a PosiTest AT-M Manual adhesion pull-off tester (DeFelsko). The adhesion pressure for the P(VDF-CTFE)/PMMA-based film on glass was measured to be 2.88 MPa.

This result indicates that the presence of the copolymer P(VDF-CTFE) in the polymeric film significantly improves the adhesion properties of the film to glass compared to neat PMMA.

### Comparative Example 1 - Adhesion in PMMA-based LSC devices

A solution of PMMA in toluene (10% by weight) containing 5% by weight of LUMOGEN® F Red 305 luminescent compound was deposited via spin coating on a 5 mm thick glass substrate. The adhesion of the PMMA polymeric coating on the glass substrate was performed by means of a PosiTest AT-M Manual adhesion pull-off tester (DeFelsko). The adhesion pressure for the PMMA-based film on glass was measured to be 1.34 MPa.

### Example 2 - Weathering in polymer (F):PMMA blend LSC devices

A solution of SOLEF® 31508 VDF-CTFE copolymer in NMP (20% by weight) was mixed with a solution of PMMA in toluene containing 5% by weight of LUMOGEN® F Red 305 luminescent compound to obtain increasing P(VDF-CTFE):PMMA weight ratios as reported in Table 1. The mixture was deposited via spin coating on a 25 mm x 25 mm x 1.8 mm transparent glass substrate to form a film of 20 $\mu$m. One silicon PV cell was attached to one edge of the transparent waveguide by means of an index-matched resin to form a LSC device. The sample was subjected to artificial weathering according to IS011341:2004(E) for a time of 1000 h of continuous light exposure (no dark cycles). The PV response of the P(VDF-CTFE)/PMMA-based LSC device was monitored during weathering time. The results are shown in Table 1.

### Comparative Example 2 - Weathering in PMMA-based LSC devices

A solution of PMMA in toluene (15% by weight) containing 5% by weight of LUMOGEN® F Red 305 luminescent compound was deposited via spin coating on a 25 mm x 25 mm x 1.8 mm transparent glass substrate to form a film of 20 $\mu$m. One silicon PV cell was attached to one edge of the transparent waveguide by means of an index-matched resin to form a LSC device. The sample was subjected to artificial weathering according to IS011341:2004(E) for a time of 1000 h of continuous light exposure (no dark cycles). The PV response of the PMMA-based LSC device was monitored during weathering time. The results are shown in Table 1.

**Table 1**

| PMMA [% wt.] | P(VDF-CTFE) [% wt.] | $\eta$ opt (0 h) [%] | $\eta$ opt (1000 h) [%] | $\eta$ opt(1000)/nopt(0 ) [%] |
|---|---|---|---|---|
| 100 | 0 | 5.80 | 4.14 | - 28.6 |
| 50 | 50 | 5.46 | 5.54 | - 1.5 |
| 40 | 60 | 5.36 | 5.38 | + 0.4 |
| 30 | 70 | 4.96 | 5.25 | + 5.8 |

As evident from the PV results obtained from the weathering tests as shown in Table 1, all the P(VDF-CTFE)/PMMA-based LSC devices fully retain their initial optical efficiency [$\eta_{opt}$] even after 1000 h of weathering. The presence of the P(VDF-CTFE) copolymer in the blend significantly improves the weatherability of the LSC device as

compared to the PMMA-based LSC device. By increasing the weight content of the P(VDF-CTFE) copolymer, a sharp improvement in the durability of the LSC is found. Surprisingly, for a weight content of the P(VDF-CTFE) copolymer equal to or larger than 60% by weight, the optical efficiency [$\eta_{opt}$] of the LSC device at 1000 h is higher than that at 0 h. This effect is increasingly more evident as the weight content of the P(VDF-CTFE) copolymer is increased up to 90% by weight. In addition, the PV performance of all the P(VDF-CTFE)/PMMA-based LSC devices significantly outperforms that of PMMA-based LSC devices after 1000 h of weathering. At 1000 h all the P(VDF-CTFE)/PMMA-based LSC devices show a higher optical efficiency [$\eta_{opt}$] as compared to the PMMA-based LSC devices. On the other side, the PMMA-based LSC device disadvantageously loses about 30% of its initial optical efficiency [$\eta_{opt}$] after 1000 h of weathering.

## Claims

1. A collector comprising at least one front layer [layer (F)] made of a composition [composition (C)] comprising at least one thermoplastic partially fluorinated polymer [polymer (F)], at least one polyacrylate [polyacrylate (A)] and at least one luminescent compound [compound (L)].

2. The collector according to claim 1, said collector further comprising at least one back layer [layer (B)].

3. The collector according to claim 2, wherein the layer (B) has a refractive index $\eta_2$ higher than the refractive index $n_1$ of at least one layer (F).

4. The collector according to any one of claims 1 to 3, wherein the polymer (F) is selected from the group consisting of:

   - polymers (F-1) comprising recurring units derived from vinylidene fluoride (VDF) and, optionally, at least one monomer (F) different from VDF, and
   - polymers (F-2) comprising recurring units derived from at least one monomer (FX) selected from tetrafluoroethylene (TFE) and chlorotrifluoroethylene (CTFE), at least one monomer (H) selected from ethylene (E), propylene and isobutylene and, optionally, at least one monomer (F) different from said monomer (FX), typically in an amount of from 0.01% to 30% by moles, based on the total amount of TFE and/or CTFE and said monomer (H).

5. The collector according to claim 4, wherein the polymer (F-1) comprises:

   (a) at least 60% by moles, preferably at least 70% by moles, more preferably at least 80% by moles of vinylidene fluoride (VDF), and
   (b) optionally, from 0.1 % to 40% by moles, preferably from 0.1 % to 30% by moles, more preferably from 0.1 % to 20% by moles, based on the total amount of monomers (a) and (b), of at least one monomer (F) selected from the group consisting of vinyl fluoride ($VF_1$), chlorotrifluoroethylene (CTFE), hexafluoropropylene (HFP), tetrafluoroethylene (TFE), trifluoroethylene (TrFE) and perfluoromethylvinylether (PMVE).

6. The collector according to claim 4, wherein the polymer (F-2) comprises:

   (a’) from 10% to 90% by moles, preferably from 30% to 70% by moles of at least one monomer (FX) selected from the group consisting of chlorotrifluoroethylene (CTFE) and tetrafluoroethylene (TFE), and
   (b’) from 10% to 90% by moles, preferably from 30% to 70% by moles, based on the total amount of monomers (a’) and (b’), of ethylene (E).

7. The collector according to any one of claims 1 to 6, wherein the polyacrylate (A) is of formula (A-1):

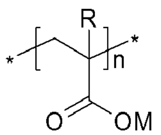

(A-1)

   wherein M is a $C_1$-$C_5$ alkyl group, R is H or $-CH_3$ and n is an integer such that the number average molecular weight of the polyacrylate (A) is of from 1000 to 1000000, preferably of from 2000 to 100000, more preferably of from 3000 to 60000.

**8.** The collector according to any one of claims 1 to 7, wherein the compound (L) is selected from the group consisting of organic compounds (L-O) and inorganic compounds (L-I).

**9.** The collector according to claim 8, wherein the compound (L) is an organic compound (L-O) of formula (L-1):

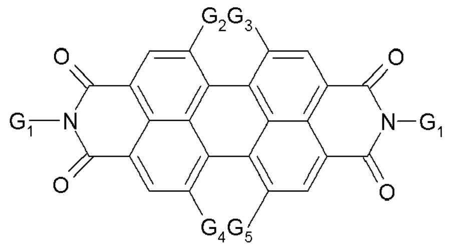

(L-1)

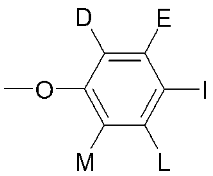

(X)

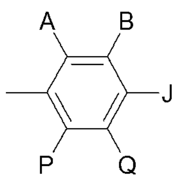

(Y)

wherein:

- $G_1$ is a linear or branched alkyl group or oxygen-containing alkyl group of formula $C_nH_{2n+1}O_m$, wherein n is an integer of from 1 to 44 and m is lower than n/2, or a group Y, wherein each of A, B, P, J and Q is independently a hydrogen atom, a fluorine atom, a methoxy group or a $C_nH_{2n+1}$ alkyl group,
wherein n is an integer from 1 to 16,
- each of $G_2$, $G_3$, $G_4$ and $G_5$ is independently a hydrogen atom, a fluorine atom, a methoxy group, a $C_nH_{2n+1}$ alkyl group, wherein n is an integer from 1 to 16, or a group X, wherein each of D, E, I, L and M is independently a hydrogen atom, a fluorine atom, a methoxy group or a $C_nH_{2n+1}$ alkyl group, wherein n is an integer from 1 to 16.

**10.** A process for the manufacture of a collector for a luminescent solar concentrator, said process comprising:

(i) providing a composition [composition (C)] comprising at least one thermoplastic partially fluorinated polymer [polymer (F)], at least one polyacrylate [polyacrylate (A)] and at least one luminescent compound [compound (L)], and
(ii) processing into a layer the composition (C) provided in step (i).

**11.** The process according to claim 10, wherein the composition (C) provided in step (i) further comprises at least one organic solvent.

**12.** The process according to claim 11, wherein under step (ii) the composition (C) is processed into a layer in liquid phase.

**13.** The process according to claim 10, wherein the composition (C) provided in step (i) is free from one or more organic solvents.

**14.** The process according to claim 13, wherein under step (ii) the composition (C) is processed into a layer in molten phase.

**15.** A luminescent solar concentrator comprising at least one collector according to any one of claims 1 to 9 and at least one photovoltaic cell.

**16.** The luminescent solar concentrator according to claim 15, wherein at least one photovoltaic cell is adhered to at least a portion of at least one collector.

**17.** The luminescent solar concentrator according to claim 15 or 16, wherein the plane of the absorption surface of at least one photovoltaic cell of the luminescent solar concentrator is substantially parallel to the plane of the layer (F)

of at least one collector.

**18.** The luminescent solar concentrator according to claim 15 or 16, wherein the plane of the absorption surface of at least one photovoltaic cell of the luminescent solar concentrator is substantially perpendicular to the plane of the layer (F) of at least one collector.

Europäisches Patentamt
European Patent Office
Office européen des brevets

# EUROPEAN SEARCH REPORT

Application Number
EP 14 18 2758

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br><br><br>A | WO 2012/021460 A2 (YOUNG MICHAEL EUGENE [US]; SRINIVAS ARJUN DANIEL [US]; ROBINSON MATTHE) 16 February 2012 (2012-02-16)<br>* paragraph [0082]; figure 8 *<br>* paragraph [0085] *<br>* paragraph [0077] - paragraph [0078] *<br>* * | 1,4,<br>7-10,15,<br>18<br>5,6 | INV.<br>H01L31/048<br>H01L31/055<br>H01L31/054 |
| A | EP 2 578 075 A1 (ASAHI GLASS CO LTD [JP]) 10 April 2013 (2013-04-10)<br>* paragraph [0014] - paragraph [0020] * | 1,10,15 | |
| A | WO 2012/015980 A2 (UNIV CALIFORNIA [US]; WINSTON ROLAND [US]; PELKA DAVID [US]) 2 February 2012 (2012-02-02)<br>* paragraph [0071] * | 1,10,15 | |
| A | WO 2010/111415 A2 (UNIV CALIFORNIA [US]; GHOSH SAYANTANI [US]; KHINE MICHELLE [US]) 30 September 2010 (2010-09-30)<br>* page 5, line 22 - page 6, line 11 * | 1,10,15 | TECHNICAL FIELDS SEARCHED (IPC) |
| X<br><br>A | EP 2 623 314 A1 (UNIV TWENTE [NL]) 7 August 2013 (2013-08-07)<br>* paragraph [0023]; figure 2 *<br>* paragraph [0030] *<br>* paragraph [0021] - paragraph [0022] *<br>* paragraph [0039] *<br>* *<br>* paragraph [0034] * | 1,2,<br>10-17<br>3 | H01L |

The present search report has been drawn up for all claims

1

| Place of search | Date of completion of the search | Examiner |
|---|---|---|
| Berlin | 10 February 2015 | Chao, Oscar |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 14 18 2758

This annex lists the patent family members relating to the patent documents cited in the above-mentioned European search report. The members are as contained in the European Patent Office EDP file on
The European Patent Office is in no way liable for these particulars which are merely given for the purpose of information.

10-02-2015

| Patent document cited in search report | Publication date | Patent family member(s) | Publication date |
|---|---|---|---|
| WO 2012021460 A2 | 16-02-2012 | AU 2011289620 A1 | 21-03-2013 |
| | | CA 2829242 A1 | 16-02-2012 |
| | | CN 103155174 A | 12-06-2013 |
| | | EP 2601688 A2 | 12-06-2013 |
| | | JP 2013535843 A | 12-09-2013 |
| | | KR 20130129912 A | 29-11-2013 |
| | | US 2012132930 A1 | 31-05-2012 |
| | | US 2015014022 A1 | 15-01-2015 |
| | | WO 2012021460 A2 | 16-02-2012 |
| EP 2578075 A1 | 10-04-2013 | CN 102905513 A | 30-01-2013 |
| | | EP 2578075 A1 | 10-04-2013 |
| | | US 2013074929 A1 | 28-03-2013 |
| | | WO 2011149028 A1 | 01-12-2011 |
| WO 2012015980 A2 | 02-02-2012 | ES 2463241 A2 | 27-05-2014 |
| | | US 2012132278 A1 | 31-05-2012 |
| | | WO 2012015980 A2 | 02-02-2012 |
| WO 2010111415 A2 | 30-09-2010 | NONE | |
| EP 2623314 A1 | 07-08-2013 | EP 2623314 A1 | 07-08-2013 |
| | | WO 2013119113 A1 | 15-08-2013 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 20090126778 A


### Non-patent literature cited in the description


- the encyclopaedia called Polymer Science Dictionary. ELSEVIER APPLIED SCIENCE, 1989, 476